Europäisches Patentamt

**European Patent Office**

Office européen des brevets

(11) Numéro de publication : **0 005 721**
**B1**

(12) FASCICULE DE BREVET EUROPÉEN

(45) Date de publication du fascicule du brevet :
17.03.82

(21) Numéro de dépôt : 79101221.4

(22) Date de dépôt : 23.04.79

(51) Int. Cl.³ : **H 01 L 21/60,** H 01 L 23/48,
H 01 L 21/285, H 01 L 29/54,
H 01 L 29/62

(54) Procédé de fabrication d'un transistor bipolaire comportant un contact de base en silicium polycristallin et un contact d'émetteur en silicium polycristallin ou en métal.

(30) Priorité : 06.06.78 US 912919

(43) Date de publication de la demande :
12.12.79 (Bulletin 79/25)

(45) Mention de la délivrance du brevet :
17.03.82 Bulletin 82/11

(84) Etats contractants désignés :
DE FR GB

(73) Titulaire : **International Business Machines Corporation**

**Armonk, N.Y. 10504 (US)**

(72) Inventeur : **Ning, Tak Hung**
**1720 Maxwell Drive**
**Yorktown Heights, N.Y. 10598 (US)**
Inventeur : **Yu, Hwa Nien**
**2849 Hickory Street**
**Yorktown Heights, N.Y. 10598 (US)**

(74) Mandataire : **Klein, Daniel**
**COMPAGNIE IBM FRANCE Département de Propriété Industrielle**
**F-06610 La Gaude (FR)**

(56) Documents cités :
DE - A - 2 516 877
DE - A - 2 618 445
EP - A - 0 001 550

IBM TECHNICAL DISCLOSURE BULLETIN
Vol. 19, Mai 1977, New York (US)
C.G. JAMBOTKAR : « Method for reducing the emitter-base contact distance in bipolar transistors » pages 4 601-4 604

IBM TECHNICAL DISCLOSURE BULLETIN
Vol. 21, Janvier 1979, New York (US)
A.W. WIEDER : « Self-aligned submicron almost ideal transistor » pages 3 166-3 169

IEEE JOURNAL SOLID-STATE CIRCUITS
Vol. SC-12, avril 1977, New York (US)
J. MIDDELHOEK et al. « Polycrystalline Silicon as a diffusion source and interconnect layer in I²L realizations », pages 135-138

Imprimerie Jouve, 18, rue St-Denis, 75001 Paris, France

Procédé de fabrication d'un transistor bipolaire comportant un contact de base en silicium polycristallin et un contact d'émetteur en silicium polycristallin ou en métal

## Domaine Technique

La présente invention concerne un procédé de fabrication de transistors bipolaires et elle se rapporte plus particulièrement à un procédé de fabrication de transistors bipolaires dont le contact de base est en silicium polycristallin et dont le contact d'émetteur, qui peut être en silicium polycristallin ou en métal, est pratiquement auto-aligné avec le contact de base, ce qui permet de produire des dispositifs présentant une très petite distance de séparation entre les contacts de base et d'émetteur de sorte que la résistance de base est réduite d'autant et que finalement le dispositif est relativement petit.

## Etat de la technique antérieure

Les transistors bipolaires, qu'ils soient de type NPN ou de type PNP, nécessitent l'établissement de contacts, effectués habituellement à travers des trous de contact appropriés, avec les régions de base, de collecteur et d'émetteur. Habituellement, ces contacts sont formés en un métal conducteur, tel que de l'aluminium. Des exemples de transistors bipolaires qui comportent des contacts de base, de collecteur et d'émetteur en métal ont été montrés dans les brevets des E.U.A. n° 3 855 007 délivré le 17 décembre 1974 aux noms de Polata et autres, n° 3 885 494, délivré le 27 mai 1975 au nom de Millar, n° 3 943 555 délivré le 9 mars 1976 aux noms de Mueller et autres et n° 3 971 059 délivré le 20 juillet 1976 aux noms de Dunkley et autres.

On sait également que le silicium polycristallin peut être utilisé pour former la porte d'un dispositif bipolaire. Dans le brevet des E.U.A. n° 4 050 975, délivré le 27 septembre 1977 aux noms d'Ipri et autres, il est décrit un procédé de fabrication de transistors bipolaires qui comportent une porte formée en silicium polycristallin et dans lesquels les portes en silicium polycristallin servent de limites de diffusion à la fois pour la diffusion d'émetteur et pour la diffusion de base. Suivant ce brevet, cependant, des interconnexions métalliques sont utilisées pour la base, l'émetteur et le collecteur et le procédé et la structure de ce brevet sont, par conséquent, différents du procédé et de la structure de la présente invention.

## Exposé de l'invention

La présente invention concerne un procédé de fabrication d'un transistor bipolaire comportant un contact de base en silicium polycristallin et un contact d'émetteur, caractérisé en ce qu'il comporte les étapes suivantes :

A. élaboration d'une structure composée d'un substrat semi-conducteur (12) du premier type de conductivité recouvert par une couche épitaxiale (10) du type de conductivité opposé, muni de régions d'isolation (18) qui définissent une région de base et une région de traversée de collecteur (16) reliée à la région de sous-collecteur enterré (14),

B. formation sur la structure obtenue d'une première couche de masquage (20) selon une configuration désirée, et formation d'une couche de silicium polycristallin (24) fortement dopée par une impureté du premier type de conductivité, en contact avec la surface de la structure au voisinage de la portion de la couche épitaxiale destinée à contenir les régions émetteur et base du transistor,

C. formation successive d'une deuxième couche de masquage (26) et d'une troisième couche de masquage (28) selon une configuration désirée, c'est-à-dire comportant une ouverture (32) au-dessus d'une partie de ladite portion du transistor, et décapage des couches sous-jacentes avec l'amplitude désirée pour mettre la structure à nu et définir notamment l'ouverture désirée dans la couche de silicium polycristallin,

D. formation de la région de base intrinsèque (38) par introduction d'une impureté du premier type de conductivité à travers cette dernière ouverture et formation de la région extrinsèque de base (34, 36) par diffusion à partir de la couche de silicium polycristallin en contact avec la surface exposée de la couche épitaxiale, simultanément à la réoxydation de ladite surface exposée,

E. gravure en se servant de la troisième couche de masquage, de la portion correspondante à l'émetteur dans la couche de réoxydation (40), formation de la région émetteur par introduction d'une impureté dudit type de conductivité opposé et élimination de la troisième couche de masquage,

F. formation successive d'une seconde couche de silicium polycristallin fortement dopée du type de conductivité opposé (43), et d'une quatrième couche de masquage (44), photogravure pour délimiter successivement deux configurations désirées des première et deuxième couches de silicium polycristallin,

G. formation d'une couche de passivation (46) selon une configuration désirée pour définir les ouvertures des trous de contact sur la structure, puis d'une couche d'un matériau conducteur (48) selon une configuration désirée pour définir les contacts de base, de collecteur et d'émetteur du transistor.

Elle concerne également une variante de ce procédé dans lequel les étapes F et G sont remplacées par les étapes suivantes :

F'. réoxydation de la structure pour former la couche (50) au-dessus de l'émetteur, formation d'une couche de masquage d'oxydation (51) selon une configuration désirée et photogravure pour délimiter une configuration désirée de la première couche de silicium polycristallin,

G'. formation d'une couche de passivation (56) selon une configuration désirée pour définir les ouvertures des trous de contact, sur la structure puis d'une couche d'un matériau conducteur (58) selon une configuration désirée pour définir les contacts de base, de collecteur et d'émetteur du transistor.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des dessins

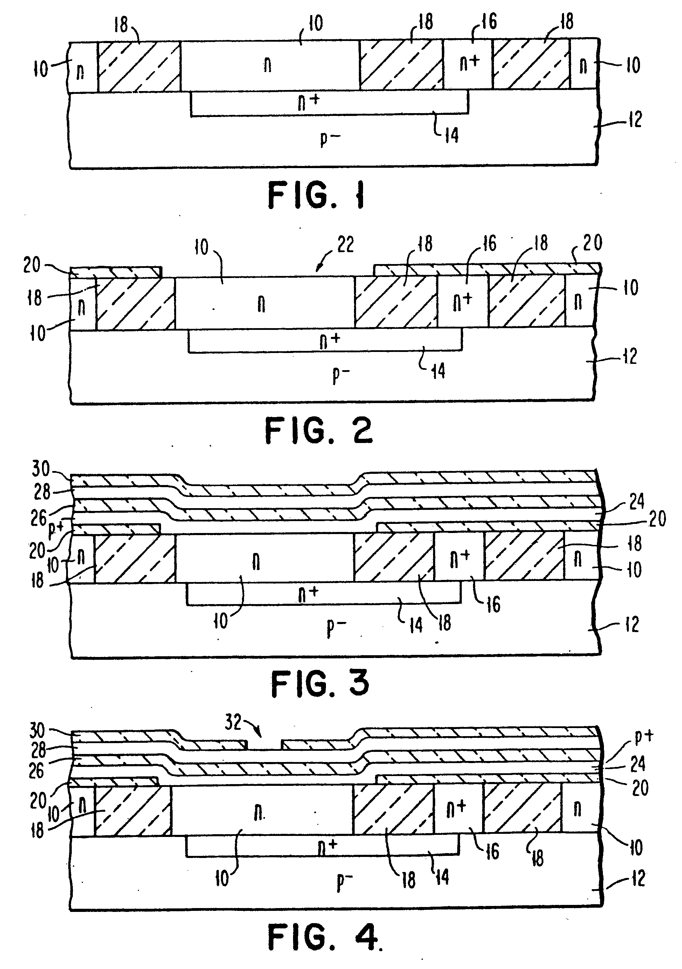

Les figures 1 à 11 sont des vues en coupe qui représentent les étapes d'un premier mode de réalisation du procédé de fabrication d'un transistor bipolaire conforme à l'invention, dans lequel les contacts de base et le contact d'émetteur sont en silicium polycristallin.

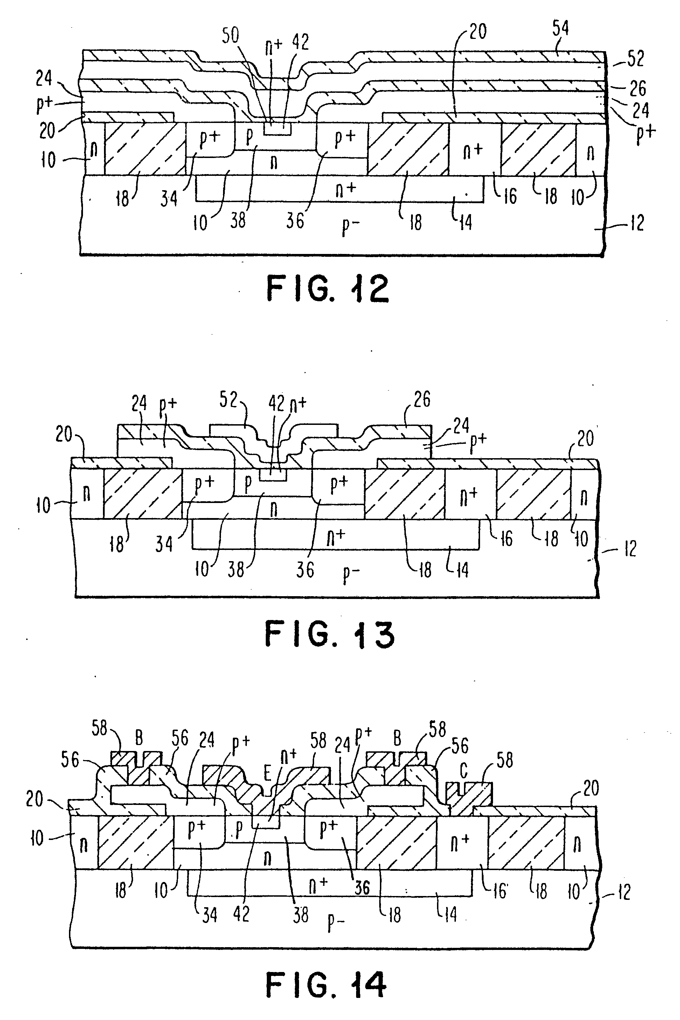

Les figures 12 à 14 sont des vues en coupe représentant les étapes qui, si elles sont exécutées après les étapes représentées sur les figures 1 à 18, sont celles d'un autre mode de réalisation du procédé de fabrication de l'invention dans lequel les contacts de base sont en silicium polycristallin et le contact d'émetteur est en métal.

Description de l'invention

L'une des limitations des performances d'un dispositif bipolaire est sa résistance de base. La résistance de base peut être réduite en formant le dispositif bipolaire avec une très petite région de base extrinsèque et en utilisant un très petit espacement entre l'émetteur et la base. On décrira ci-après un procédé selon lequel on fabrique un transistor bipolaire dont l'émetteur est auto-aligné avec le(s) contact(s) de base en silicium polycristallin ce qui a pour effet de fournir une très petite distance de séparation entre les contacts de base et d'émetteur. La résistance de base est ainsi réduite et le dispositif actif est rendu plus petit. Les contacts de base en silicium polycristallin ne nécessitent pas l'ouverture de trous de contact délimités par un masque dans la région active du dispositif. Il en résulte une région de base extrinsèque bien plus petite et, de ce fait, une capacité de collecteur considérablement réduite, ces avantages conduisent à la réalisation d'un dispositif à performances élevées.

Le procédé de fabrication de la présente invention permet de réaliser un transistor bipolaire ayant un contact de base en silicium polycristallin et un contact d'émetteur en silicium polycristallin en utilisant les étapes représentées sur les figures 1 à 11 ou un transistor bipolaire ayant un contact de base en silicium polycristallin et un contact d'émetteur métallique en utilisant les étapes représentées sur les figures 1 à 8 et 12 à 14.

A l'étape représentée sur la figure 1, on dépose une couche épitaxique 10 composée, par exemple, d'une matière semi-conductrice du type n sur un substrat 12 tel que du silicium de type p. On forme une région de sous-collecteur enterré 14, par exemple par diffusion d'une impureté de type n dans le substrat 12 préalablement au dépôt épitaxial en utilisant les techniques de diffusion classique. On forme également une région de traversée 16 reliée au sous-collecteur et des régions d'isolement 18 en oxyde.

Au cours de l'étape 2, on forme une première couche de masquage 20 en matière isolante, telle que du dioxyde de silicium ($SiO_2$) sur la couche 10 et on forme une ouverture 22 qui correspond à la portion de la couche épitaxiale définie par les régions d'isolement 18, cette portion est destinée à recevoir le transistor, en utilisant les techniques photolithographiques classiques.

Au cours de l'étape 3, on dépose une couche 24 de silicium polycristallin fortement dopé au bore, donc de type $p^+$, en utilisant les techniques de dépôt de vapeur chimique classiques. En pratique, si la pénétration du bore à travers la couche isolante 20 en dioxyde de silicium pose des problèmes, on peut appliquer une couche supplémentaire de nitrure de silicium sur la couche 20 de dioxyde de silicium au cours de l'étape 2. Ensuite, on dépose une deuxième couche de masquage 26 de dioxyde de silicium, une troisième couche de masquage 28 d'oxyde d'aluminium ($Al_2O_3$) et une couche 30 de dioxyde de silicium, en utilisant les techniques de dépôt de vapeur chimique classiques. La couche 28 d'oxyde d'aluminium sera utilisée comme masque d'oxydation et comme masque de gravure. La technique de décapage par des ions réactifs sera utilisée pour la gravure du dioxyde de silicium. Cependant, d'autres matériaux sont utilisables aux mêmes fins, tels que le nitrure de silicium, peuvent être employés à la place de l'oxyde d'aluminium, à condition que la couche supérieure 30 de dioxyde de silicium soit suffisamment épaisse pour masquer le nitrure de silicium au cours de l'étape de gravure par ions réactifs.

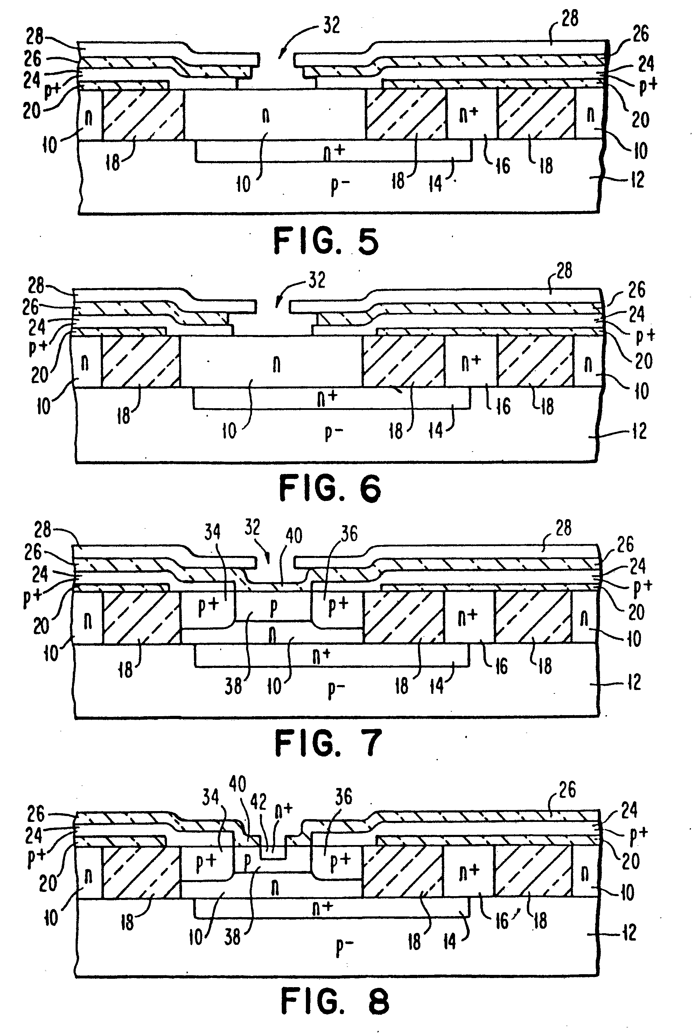

Au cours de l'étape 4, on utilise les techniques photolithographiques pour ouvrir la couche 30 de dioxyde de silicium afin de former une ouverture 32 correspondant à la région d'émetteur. On grave successivement à travers cette ouverture la couche 28 de dioxyde d'aluminium et la couche 26 de dioxyde de silicium. Ensuite, en utilisant une solution d'attaque, telle qu'une solution de HF: $HNO_3$:$CH_3COOH$, dans le rapport 1: 3: 8, à laquelle on a ajouté de l'eau oxygénée ($H_2O_2$) en tant qu'agent oxydant, on grave préférentiellement la couche 24 de silicium polycristallin fortement dopée de type $p^+$ en produisant volontairement un décapage latéral sous-jacent important pour former la structure représentée sur la figure 5. On peut également commencer le décapage de la couche 24 avec les ions réactifs et finir la gravure en utilisant la solution d'attaque mentionnée ci-dessus. Cette combinaison de la gravure par ions réactifs et de la gravure par voie chimique humide, permet une meilleure modulation de l'importance du décapage latéral sous-jacent.

L'étape suivante consiste à accroître la gravure de la couche 26 de dioxyde de silicium qui est en surplomb au-dessus de la couche 24 de silicium polycristallin pour obtenir la structure représentée sur la figure 6.

Au cours de l'étape représentée sur la figure 7, on forme la base intrinsèque 38 par diffusion de bore. Pendant l'étape d'étalement du bore, les régions de base extrinsèques 34 et 36 sont formées à partir de la couche 24 de silicium polycristallin de type p⁺. Ensuite, on fait croître une couche 40 de dioxyde de silicium sur les côtés de la couche 24 de silicium polycristallin et au-dessus de la région de base intrinsèque 38.

En utilisant la couche 28 d'oxyde d'aluminium comme masque de gravure, et la technique de décapage par ions réactifs, on grave la partie de la couche 40 en dioxyde de silicium qui définit les dimensions de l'émetteur. Ensuite, on implante de l'arsenic pour former l'émetteur 42, comme représenté sur la figure 8. On enlève ensuite la couche 38 d'oxyde d'aluminium ; on peut également enlever la couche 28 d'oxyde d'aluminium avant l'étape d'implantation de l'émetteur.

A ce stade du processus de fabrication, les régions de base 34 et 36 qui en fait ne forment qu'une seule région : la région extrinsèque de base, sont en contact avec la couche 24 de silicium polycristallin et la région d'émetteur 42 est à nu. Les étapes suivantes du procédé dépendent du matériau de contact choisi selon que l'on désire former un contact d'émetteur en silicium polycristallin ou un contact d'émetteur en métal.

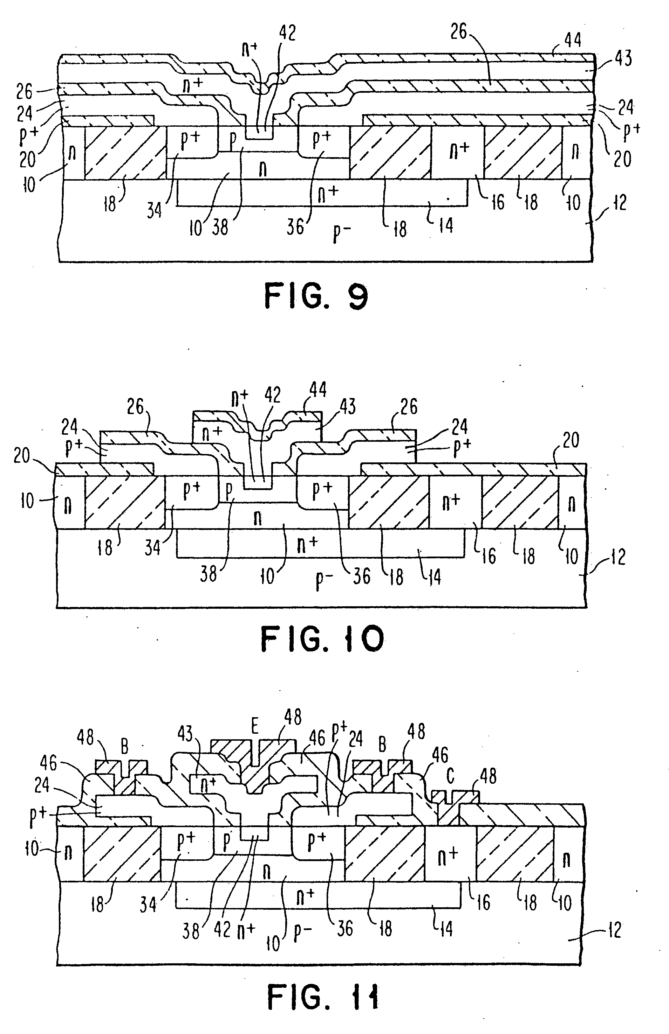

Pour former un contact d'émetteur en silicium polycristallin, on exécute les étapes représentées sur les figures 9 à 11. Comme représenté sur la figure 9 à laquelle on se référera, on dépose une seconde couche 43 de silicium polycristallin fortement dopé à l'arsenic, de type n⁺, en utilisant un procédé de dépôt de vapeur chimique, puis on dépose une quatrième couche de masquage 44 en dioxyde de silicium, en utilisant également un procédé de dépôt de vapeur chimique. Ensuite, en utilisant deux étapes de masquage et de gravure classiques séparées, on délimite le contact de base 24 en silicium polycristallin et le contact d'émetteur 43 en silicium polycristallin, tandis que l'on étale simultanément la jonction. La structure obtenue est représentée sur la figure 10.

Enfin, on forme une autre couche 46 de dioxyde de silicium par dépôt de vapeur chimique et on ouvre un trou de contact au-dessus de la couche de silicium polycristallin 43 qui forme le contact avec l'émetteur, le (ou les) trou(s) de contact avec le silicium polycristallin 24 de la base et le trou de contact avec la région de traversée 16 reliée au sous-collecteur. On dépose une couche de métal 48 et on délimite la configuration désirée de lignes et de contacts de deuxième niveau, notamment avec les contacts de premier niveau en polysilicium polycristallin formant contact avec les régions base, collecteur et émetteur. La structure finale est représentée sur la figure 11.

On voit, par conséquent, que l'émetteur 24 comporte un contact 43 de premier niveau en silicium polycristallin, que les régions de base 34 et 36 comportant des contacts de premier niveau 24 en silicium polycristallin ; en outre le contact d'émetteur 43 est auto-aligné avec le contact de base 24 du fait que la fenêtre (ou ouverture) formée dans la couche 28 d'oxyde d'aluminium a été utilisée pour délimiter le contact de base, au cours de l'étape représentée sur la figure 5 d'une part, et pour délimiter l'ouverture de l'émetteur, au cours de l'étape représentée sur la figure 8 d'autre part.

Si l'on désire former un contact d'émetteur de premier niveau en métal, le procédé est identique à celui qui vient d'être décrit ci-dessus jusqu'à l'obtention de la structure montrée sur la figure 8. Cette variante d'exécution ne nécessite donc que très peu de modifications. On forme alors successivement une mince couche 50 de dioxyde de silicium sur l'émetteur 40, une couche 52 de nitrure de silicium et une couche 54 de dioxyde de silicium. Ces dépôts peuvent être effectués au moyen de procédés de dépôt de vapeur chimique. La structure est représentée sur la figure 12. La couche 52 de nitrure de silicium sera utilisée comme couche de masquage d'oxydation au cours de l'étape de croissance d'oxyde ultérieure.

En utilisant deux étapes de masquage et de gravure séparées, on délimite la couche 52 de nitrure de silicium et la couche 24 de silicium polycristallin de la manière représentée sur la figure 13.

Au cours de l'étape suivante représentée sur la figure 14, on étale l'émetteur et on fait croître simultanément une couche 56 de dioxyde de silicium sur les côtés de la couche 24 de silicium polycristallin, par oxydation de cette dernière. On ouvre les trous de contact dans l'oxyde pour atteindre le silicium polycristallin de base 24 et la région de traversée 16. On enlève la couche 52 de nitrure de silicium (figure 13) et on grave par immersion la couche 50 de dioxyde de silicium au-dessus de l'émetteur 42 pour découvrir l'émetteur 42 en vue de l'établissement d'un contact en métal. Enfin, on dépose une couche 58 de métal et on la délimite selon une configuration désirée pour former un contact d'émetteur E en métal et pour établir le contact de deuxième niveau en métal de base B avec la couche 24 en silicium polycristallin et avec la région de traversée 16 pour constituer le contact de collecteur C.

Dans les modes de réalisation décrits, la technique d'isolement par oxyde encastré a été utilisée ; cependant, il est évident que la présente invention est applicable à d'autres techniques d'isolement, telles que la technique d'isolement par diffusion ou une technique combinée d'isolement par diffusion et par oxyde encastré. De même, on peut utiliser d'autres matériaux connus, à la place des matériaux spécifiques mentionnés dans la description.

Possibilités d'application industrielle

Le procédé de la présente invention peut être utilisé pour fabriquer des transistors bipolaires du type de ceux qui sont largement utilisés dans l'industrie électronique. Du fait que le procédé permet de réaliser un transistor bipolaire ayant une faible distance de séparation entre les contacts de base et d'émetteur, on peut construire le transistor avec de plus petites dimensions et ceci est important dans la fabrication des circuits dans lesquels il est nécessaire d'intégrer les composants avec une très forte densité. Cet avantage s'ajoute à la réduction de la résistance de base qui a pour effet l'obtention de performances élevées. Etant donné que les contacts de base en silicium polycristallin fabriqués conformément au procédé de la présente invention ne nécessitent pas l'ouverture de trous de contact délimités par un masque dans la région active du dispositif, il n'est besoin que d'une petite zone de base extrinsèque et, par conséquent, le transistor présente une capacité de collecteur réduite ce qui accroît encore les performances. En outre, les contacts avec le silicium polycristallin de la base peuvent être établis dans des emplacements appropriés relativement éloignés de la région active du dispositif, ce qui augmente le nombre des configurations de câblage éventuelles qui peuvent être utilisées. C'est une caractéristique importante dans les agencements de circuits à haute densité. Cet avantage est encore plus marqué dans le cas où le contact d'émetteur est en silicium polycristallin. Dans ce cas en effet, le contact de deuxième niveau avec le silicium polycristallin de l'émetteur peut être établi à des emplacements appropriés, relativement éloignés de la région d'émetteur $n^+$, accroissant ainsi les possibilités de câblage des circuits.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de fabrication d'un transistor bipolaire comportant un contact de base en silicium polycristallin et un contact d'émetteur, pratiquement auto-aligné avec le contact de base, et à très petite distance de ce dernier, du genre comprenant l'étape :

A. élaboration d'une structure composée d'un substrat semi-conducteur (12) du premier type de conductivité recouvert par une couche épitaxiale (10) du type de conductivité opposé, muni de régions d'isolation (18) qui définissent une région de base et une région de traversée de collecteur (16) reliée à la région de sous-collecteur enterré (14), caractérisé en ce qu'il comprend en outre les étapes de :

B. formation sur la structure obtenue d'une première couche de masquage (20) selon une configuration désirée, et formation d'une couche de silicium polycristallin (24) fortement dopée par une impureté du premier type de conductivité, en contact avec la surface de la structure au voisinage de la portion de la couche épitaxiale destinée à contenir les régions émetteur et base du transistor,

C. formation successive d'une deuxième couche de masquage (26) et d'une troisième couche de masquage (28) selon une configuration désirée, c'est-à-dire comportant une ouverture (32) au-dessus d'une partie de ladite portion du transistor, et décapage des couches sous-jacentes (26, 24) de telle sorte que l'ouverture (32) présente des bords en surplomb vis-à-vis des bords de l'ouverture pratiquée dans la couche de silicium polycristallin (24),

D. formation de la région de base intrinsèque (38) par introduction d'une impureté du premier type de conductivité à travers cette dernière ouverture et formation de la région extrinsèque de base (34, 36) par diffusion à partir de la couche de silicium polycristallin en contact avec la surface exposée de la couche épitaxiale, simultanément à la réoxydation de ladite surface exposée,

E. gravure en se servant de la troisième couche de masquage, de la portion correspondante à l'émetteur dans la couche de réoxydation (40), formation de la région émetteur par introduction d'une impureté dudit type de conductivité opposé et élimination de la troisième couche de masquage,

F. formation successive d'une seconde couche de silicium polycristallin fortement dopée du type de conductivité opposé (43), et d'une quatrième couche de masquage (44), photogravure pour délimiter successivement deux configurations désirées des première et deuxième couches de silicium polycristallin,

G. formation d'une couche de passivation (46) selon une configuration désirée pour définir les ouvertures des trous de contact sur la structure, puis d'une couche d'un matériau conducteur (48) selon une configuration désirée pour définir les contacts de base, de collecteur et d'émetteur du transistor.

2. Procédé de fabrication selon la revendication 1 caractérisé en ce que les étapes F et G sont remplacées par les étapes suivantes :

F'. réoxydation de la structure pour former la couche (50) au-dessus de l'émetteur, formation d'une couche de masquage d'oxydation (52) selon une configuration désirée et photogravure pour délimiter une configuration désirée de la première couche de silicium polycristallin,

G'. formation d'une couche de passivation (56) selon une configuration désirée pour définir les ouvertures des trous de contact, sur la structure puis d'une couche d'un matériau conducteur (58) selon une configuration désirée pour définir les contacts de base, de collecteur et d'émetteur du transistor.

3. Procédé selon la revendication 1 ou 2 caractérisé en ce que les impuretés du premier type de conductivité sont du bore, et celles du type de conductivité opposé de l'arsenic.

4. Procédé selon la revendication 1, 2 ou 3 caractérisé en ce que les première et deuxième couches de masquage sont en $SiO_2$, et la troisième couche de masquage en $Al_2O_3$.

5. Procédé selon la revendication 1, 2, 3 ou 4 caractérisé en ce que l'étape de formation de l'émetteur comprend une implantation ou une diffusion.

6. Procédé selon la revendication 1, 2, 3, 4 ou 5 caractérisé en ce que l'étape de gravure de l'étape E s'effectue par décapage par des ions réactifs.

**Claims**

1. Method for fabricating a bipolar transistor comprising a polycrystalline silicon base contact and an emitter contact which is practically self-aligned with the base contact and located a very small distance from the latter, the method including the step of :

A. forming a structure composed of a semiconductor substrate (12) of the first type of conductivity, covered with an epitaxial layer (10) of the opposite type of conductivity, provided with isolating regions (18) which define a base region and a collector through region (16) connected with the buried subcollector region (14), characterized in that it further includes the steps of :

B. forming on the structure thus obtained a first masking layer (20) according to a desired pattern, and forming a polycrystalline silicon layer (24) strongly doped with an impurity of the first type of conductivity, in contact with the surface of the structure in the vicinity of the portion of the epitaxial layer which is to contain the emitter and base regions of the transistor,

C. forming successively a second masking layer (26) and a third masking layer (28) according to a desired pattern, that is, providing a window (32) over part of said portion of the transistor, and etching the underlying layers (26, 24) in such a way that the window (32) has overhanging edges with respect to the edges of the window opened in the polycrystalline silicon layer (24),

D. forming the intrinsic base region (38) by introducing an impurity of the first type of conductivity through the latter window and forming the extrinsic base region (34, 36) by diffusion from the polycrystalline silicon layer in contact with the exposed surface of the epitaxial layer, simultaneously with the reoxidation of said exposed surface,

E. etching by means of the third masking layer the portion corresponding to the emitter in the reoxidation layer (40), forming the emitter region by introducing an impurity of said opposite type of conductivity and eliminating the third masking layer,

F. forming successively a second, strongly doped polycrystalline silicon layer of opposite conductivity (43) and a fourth masking layer (44), photoetching to delimit successively two desired patterns of the first and second polycrystalline silicon layers,

G. forming a passivation layer (46) according to a desired pattern to define the windows of the contact holes on the structure, and then a layer of conductive material (48) according to a desired pattern to define the base, collector and emitter contacts of the transistor.

2. Fabrication method according to claim 1, characterized in that steps F and G are replaced with the following steps :

F'. reoxidizing the structure to form the layer (50) over the emitter, forming an oxidation masking layer (52) according to a desired pattern and photoetching to delimit a desired pattern of the first polycrystalline silicone layer,

G'. forming a passivation layer (56) according to a desired pattern to define the windows of the contact holes on the structure, and then a layer of conductive material (58) according to a desired pattern to define the base, collector and emitter contacts of the transistor.

3. Method according to claim 1 or 2, characterized in that the impurities of the first type of conductivity are of boron and those of the opposite type of conductivity of arsenic.

4. Method according to claim 1, 2 or 3, characterized in that the first and second masking layers are of $SiO_2$ and the third masking layer of $Al_2O_3$.

5. Method according to claim 1, 2, 3 or 4, characterized in that the step of forming the emitter comprises an implantation or a diffusion step.

6. Method according to claim 1, 2, 3, 4 or 5, characterized in that the etching process of step E uses reactive ion etching.

**Ansprüche**

1. Verfahren zum Herstellen eines bipolaren Transistors mit einem Basiskontakt aus polykristallinem Silicium und mit einem Emitterkontakt, der praktisch mit dem Basiskontakt selbstausgerichtet und in sehr geringer Entfernung davon angeordnet ist, das folgenden Verfahrensschritt einschließt :

A. Herstellen einer Struktur, bestehend aus einem Halbleitersubstrat (12) des ersten Leitfähigkeitstyps, auf des eine Epitaxialschicht (10) des entgegengesetzten Leitfähigkeitstyps aufgetragen ist, und das Isolationsbereiche (18) einschließt, die einen Basisbereich und einen mit dem vergrabenen Subkollektorbereich (14) verbundenen Kollektordurchgangsbereich (16) definieren, dadurch gekennzeichnet, daß es außerdem die folgenden Verfahrensschritte einschließt :

B. Bildung auf der erhaltenen Struktur einer ersten Maskierungsschicht (20) nach einem gewünschten Muster, und Bildung einer mit einem Fremdstoff des ersten Leitfähigkeitstyps stark dotierten Schicht aus polykristallinem Silicium (24) in Kontakt mit der Oberfläche der Struktur in der Nähe des Epitaxialschichtteils, der zur Aufnahme des Emitter- und Basisbereichs des Transistors bestimmt ist,

C. Bildung nacheinander einer zweiten Maskierungsschicht (26) und einer dritten Maskierungsschicht (28) nach einem gewünschten Muster, d.h. mit einer Öffnung (32) über einem Teil des Transistorabschnittes, und Ätzen der darunterliegenden Schichten (26, 24) derart, daß die Öffnung (32) gegenüber den Rändern der in der polykristallinen Siliciumschicht (24) eingebrachten Öffnung überhängende Ränder aufweist,

D. Bildung des intrinsischen Basisbereichs (38) durch Einbringen eines Fremdstoffes der ersten Leitfähigkeit durch diese letztere Öffnung und Bildung eines extrinsischen Basisbereichs (34, 36) durch Diffusion von der polykristallinen Siliciumschicht aus in Kontakt mit der freiliegenden Oberfläche der Epitaxialschicht, unter gleichzeitiger Reoxydation dieser freiliegenden Oberfläche,

E. Ätzen des dem Emitter in der Reoxydationsschicht (40) entsprechenden Teils mit Hilfe der dritten Maskierungsschicht, Herstellen des Emitterbereichs durch Einbringen eines Fremdstoffes des entgegengesetzten Leitfähigkeitstyps und Beseitigung der dritten Maskierungsschicht,

F. Herstellen einer zweiten, stark dotierten polykristallinen Siliciumschicht des entgegengesetzten Leitfähigkeitstyps (43), und danach einer vierten Maskierungsschicht (44), Photoätzen, um nacheinander zwei gewünschte Muster der ersten und zweiten polykristallinen Siliciumschicht abzugrenzen,

G. Herstellen einer Passivierungsschicht nach einem gewünschten Muster zum Definieren der Öffnungen der Kontaktlöcher auf der Struktur und danach einer aus einem leitenden Material bestehenden Schicht (48) zum Definieren des Basis-, Kollektor- und Emitterkontaktes des Transistors.

2. Fabrikationsverfahren nach Anspruch 1, dadurch gekennzeichnet, daß die Verfahrensschritte F und G durch folgende Verfahrensschritte ersetzt werden :

F'. Reoxydation der Struktur, um über dem Emitter eine Schicht (50) zu bilden, Herstellen einer Oxydations-Maskierungsschicht (52) nach einem gewünschten Muster, und Photoätzen zum Abgrenzen eines gewünschten Musters der ersten polykristallinen Siliciumschicht,

G'. Herstellen einer Passivierungsschicht (56) nach einem gewünschten Muster zum Definieren der Öffnungen der Kontaktlöcher auf der Struktur und danach einer aus leitendem Material bestehenden Schicht (58) zum Definieren des Basis-, Kollektor- und Emitterkontaktes des Transistors.

3. Verfahren nach Anspruch 1 oder 2, dadurch gekennzeichnet, daß die Fremdstoffe des ersten Leitfähigkeitstyps aus Bor und die des entgegengesetzten Leitfähigkeitstyps aus Arsen bestehen.

4. Verfahren nach Anspruch 1, 2 oder 3, dadurch gekennzeichnet, daß die erste und zweite Maskierungsschicht aus $SiO_2$ und die dritte Maskierungsschicht aus $Al_2O_3$ bestehen.

5. Verfahren nach Anspruch 1, 2, 3 oder 4, dadurch gekennzeichnet, daß der Verfahrensschritt zum Bilden des Emitters einem Implantations- und Diffusionsprozeß einschießt.

6. Verfahren nach Anspruch 1, 2, 3, 4 oder 5, dadurch gekennzeichnet, daß der Ätzprozeß des Verfahrensschritts E mit Hilfe des reaktiven Ionenätzens durchgeführt wird.

FIG. 1

FIG. 2

FIG. 3

FIG. 4.

FIG. 5

FIG. 6

FIG. 7

FIG. 8

**FIG. 9**

**FIG. 10**

**FIG. 11**

FIG. 12

FIG. 13

FIG. 14